(19) Europäisches Patentamt
European Patent Office
Office européen des brevets

(11) **EP 1 598 497 B1**

(12) **EUROPEAN PATENT SPECIFICATION**

(45) Date of publication and mention
of the grant of the patent:
**05.05.2010 Bulletin 2010/18**

(51) Int Cl.:
*E04B 1/92* (2006.01)   *D06M 15/55* (2006.01)
*E04C 5/07* (2006.01)   *B29B 11/16* (2006.01)
*D04C 1/12* (2006.01)   *B29C 70/88* (2006.01)
*B29K 105/08* (2006.01)

(21) Application number: **03816063.6**

(22) Date of filing: **27.02.2003**

(86) International application number:
**PCT/JP2003/002258**

(87) International publication number:
**WO 2004/076766 (10.09.2004 Gazette 2004/37)**

(54) **USE OF A LOW-MAGNETISM, LOW-CONDUCTIVITY CONSTRUCTION MATERIAL HAVING IMPROVED ELECTROMAGNETIC WAVE TRANSMITTANCE**

BENUTZUNG EINES BAUSTOFFS MIT GERINGEM MAGNETISMUS, GERINGER LEITFÄHIGKEIT UND VERBESSERTER ELEKTROMAGNETWELLENÜBERTRAGUNG

UTILISATION D'UN MATERIAU DE CONSTRUCTION A FAIBLE MAGNETISME, FAIBLE CONDUCTIVITE PRESENTANT UNE MEILLEURE TRANSMITTANCE DES ONDES ELECTROMAGNETIQUES

(84) Designated Contracting States:
**AT BE BG CH CY CZ DE DK EE ES FI FR GB GR HU IE IT LI LU MC NL PT SE SI SK TR**

(43) Date of publication of application:
**23.11.2005 Bulletin 2005/47**

(73) Proprietors:
• **Fibex Co., Ltd.**
**Tokyo 103-0022 (JP)**
• **DU PONT-TORAY COMPANY, LTD.**
**Chuo-ku,**
**Tokyo 103-0023 (JP)**

(72) Inventors:
• **Kosuge, Kazuhiko,**
**c/o Du Pont-Toray Co., Ltd.**
**Tokyo 103-0023 (JP)**
• **Sumida, Atsushi,**
**c/o Du Pont-Toray Co., Ltd.**
**Tokyo 103-0023 (JP)**
• **Matsubara, Sumiyuki,**
**c/o Fibex Co., Ltd.**
**Chuo-ku**
**Tokyo 103-0022 (JP)**

• **Kosugi, Kazumasa,**
**c/o Fibex Co., Ltd.**
**Chuo-ku,**
**Tokyo 103-0022 (JP)**

(74) Representative: **Teipel, Stephan**
**Lederer & Keller**
**Patentanwälte**
**Prinzregentenstrasse 16**
**80538 München (DE)**

(56) References cited:
**JP-A- 9 217 463    JP-A- 2002 326 285**

• **DANIEL B. MIRACLE AND STEVEN L. DONALDSON: "ASM Handbook" 2001, ASM , USA , XP002474761 ISBN: 0-87170-703-9 * page 41 - page 45 * * page 78 - page 89 * * page 803 - page 837 ***
• **MARK . BIKALES . OVERBERGER . MENGES: "Encyclopedia of Polymer Science and Engineering" 1988, WILEY-INTERSCIENCE , USA , XP002474762 ISBN: 0-471-80945-4 * page 685; figure 9 ***

## Description

Technical Field

The present invention relates to the use of a low magnetic and low conductive structural material, and particularly to a low magnetic and low conductive structural material of improved electromagnetic permeability.

Background Art

Conventional architectures of concrete structure employ reinforcing steel bars and steel-frames for improving tensile strengths thereof. Such materials are employed in large quantities since they are of low costs and exhibit large mechanic strength. However, reinforcing steel bars are magnetic bodies and are electrically conductive. Moreover, since lightning conductor facilities of such buildings are generally connected with reinforcing steel bars, high voltage and large current are transmitted over a wide range through the reinforcing steel bars when applied with an electric shock owing to a thunder stroke, thereby to cause problems of malfunctions or damages of electric and electronic appliances caused through generation of strong electromagnetic induction on the periphery thereof.

When installing a switchboard, such a switchboard is supported by the reinforcing steel bar through methods such as welding, and owing to an electric field that has been induced into the reinforcing steel bar by an electric field generated from the switchboard even though the switchboard is connected to grounding wires, unwanted current is made to flow through the reinforcing steel bar. Even in the case where special care is given for insulation from the reinforcing steel bar for separating the switchboard, electromagnetic induction is caused by current flowing through the switchboard, resulting in generation of current also in adjacently located reinforcing steel bars. In addition thereto, electric noise that is induced from other equipments within the building is also transmitted through the reinforcing steel bar to generate induced current.

Current flowing through the reinforcing steel bar caused by those factors inside and outside of the buildings is referred to as stray current, wherein such stray current enters into precision equipments such as computers upon being transmitted through the reinforcing steel bar as well as the grounding wires connected to the reinforcing steel bar, thereby causing drawbacks such as malfunctions or damages of the precision equipments.

Further, in constructing concrete structures, remanences are generated in the reinforcing steel bars by an electromagnet that is used when transporting the reinforcing steel bars or by a current used for performing welding at construction sites so that the remaining magnetism after completion of construction may badly affect, for instance, electronic equipments within or around these structures. Moreover, in facilities employing strong magnetic force such as nuclear fusion facilities and superconducting power storage facilities, induced current is made to flow through the reinforcing steel bar by magnetic force to disturb magnetic fields within the above facilities so that sources of magnetic force and electronic appliances within those facilities are badly affected.

Also in view of building construction, corrosion of reinforcing steel bar is apt to occur through electric corrosion owing to stray current to arise drawbacks in that the strength of the building is degraded upon reduction of sectional areas of reinforcing steel bars.

Reinforcing steel also exhibits properties of reflecting electromagnetic waves. Through reflection of electromagnetic waves by the reinforcing steel bar, there are caused problems of interference of electromagnetic waves, ghost phenomena and also malfunctions and damages of electric and electronic appliances resulting therefrom. A ghost phenomenon is a phenomenon in which a reflected image other than the normal image appears at a position shifted from the normal image in a double or multiple manner on, for instance, a screen of a TV receiver. This occurs when electromagnetic waves that directly arrive from a transmitting antenna to a receiving point and electromagnetic waves that have been reflected by a building including reinforcing steel bar arrive with time difference.

As described above, a large variety of problems are caused owing to the magnetic, conductive and electromagnetic reflecting properties of reinforcing steel bars.

On the other hand, electromagnetic waves that are generated and irradiated are on the rise accompanying the scale up of utilization of wireless applications such as digital equipments and cellular phones, and electromagnetic environmental pollution is expected to become even worse. Moreover, remarkable developments of achieving downsizing and a low-voltage structure in electric and electronic appliances are being made so that the resistance of such electric and electronic appliances to electromagnetic waves is currently becoming extremely vulnerable, and the number of cases in which electromagnetic damages are caused is also increasing yearly.

As explained so far, it is currently the case that reinforcing steel bar includes a large number of problems related to electromagnetic waves and current, and that electromagnetic environmental pollution is growing so that it is necessary to develop electromagnetic-environmental infrastructures that suit the information technological society. It is accordingly being wanted for emergence of a structural material that substitutes reinforcing steel bar, and particularly of a structural material with low-magnetism and low-conductivity, excellent electromagnetic permeability, and strength equivalent to that of reinforcing steel bar.

Document JP 2002 326285 discloses a low magnetic and low conductive structural material having an improved electromagnetic permeability, comprising a straight or bent fiber-reinforced plastic wherein braids made of continuous fiber are reinforced with a plastic.

## Disclosure of the Invention

It is an object of the present invention to provide a novel structural material that is of extremely low magnetism and conductivity and that has a physical property (such as strength) equivalent to or exceeding that of reinforcing steel bar.

The inventors of the present invention have studied intensively for solving the above problems, and as a result, they have succeeded in creating a structural material that is made of fiber-reinforced plastic in which braids of continuous fiber are reinforced by plastic and that exhibits a particular physical property of particular values, and they have further found that this material is capable of totally solving the above problems.

More particularly, as a result of various studies, the inventors of the present invention have found out that a reinforced plastic obtained by reinforcing a para-aramid fiber with an epoxy resin is particularly preferable, and that by using this material, there can be provided a low-magnetic and low-conductive structural material having a strength equivalent to or exceeding that of reinforcing steel bar, and having functions and physical properties that are variously superior and of improved electromagnetic permeability .

Further studies have been made to complete the present invention

In other words, the present invention relates to the use of:

1) a low-magnetic and low-conductive structural material having an improved electromagnetic permeability, comprising a straight or bent fiber-reinforced plastic wherein braids made of continuous fiber are reinforced with a plastic, characterized in that

(1) the said structural material is alkali resistant with a tensile strength retention of not less than 90% over 1,500 hours, measured in accordance with JSCE-E538-1995

(2) the said structural material is heat resistant with a tensile strength retention of not less than 90% after performing heat treatment at 220°C for 1 hour, measured in accordance with JSCE-E531-1995,

(3) the said structural material has a volume resistivity with an electric resistivity of not less than $10^{13}$ $\Omega$·cm, measured in accordance with JIS C 6481,

(4) the said structural material has an electromagnetic permeability of substantially 100%, measured in accordance with the Advantest method as recited on page 1059 of Summaries of Annual Meeting on 1996 of the Architectural Institute of Japan,

(5) the said structural material has a bond stress of 100 to 150 kgf/cm$^2$ to concrete when the amount of slippage at free side is 2 mm, measured in accordance with JSCE-E539-1995,

(6) the said structural material has a tensile strength of not less than 1.0 kN/mm$^2$, measured in accordance with JSCE-E531-1995, and a tensile modulus of not less than 60 kN/mm$^2$, measured in accordance with JSCE-E531-1995, and

(7) the said structural material has a magnetic susceptibility of substantially 0 H/m, measured in accordance with JIS C 2501.

for the construction of a building

2) the structural material as described in the above 1), wherein the continuous fiber is a para-aramid fiber,

3) the structural material as described in the above 2), wherein the para-aramid fiber has a tensile modulus of not less than 90 kN/mm$^2$, measured in accordance with JSCE-E531-1995,

4) the structural material as described in the above 1), wherein the plastic is an epoxy resin,

5) the structural material as described in the above 4), wherein the epoxy resin has a radiation resistance of not less than 90 MGy, and

6) the structural material as described in the above 1) wherein the building is an Information Technology (IT) building.

## Best Mode for Carrying Out the Invention

The low-magnetic and low-conductive structural material used according to the present invention is a fiber reinforced plastic having a physical property of the above-discussed specific values, comprising braids which are made of continuous fibers and are reinforced with plastics. Constitutive ingredients of such structural materials include continuous fiber and plastic.

The continuous fiber include, for instance, organic fibers such as aramid fiber, polyester fiber, high-strength polyolefin fiber, strong polyamide fiber and strong polyvinyl alcohol fiber, and inorganic fibers such as carbon fiber, glass fiber and ceramic fiber, and these may be employed alone or in combination. Among these, aramid fiber is particularly preferable. Aramid fiber may be roughly classified into para-aramid fiber and meta-aramid fiber. The para-aramid fiber specifically includes polyparaphenylene terephthalamide fiber (made by Du-Pont-Toray Co., Ltd., product name: KEVLAR™) and copolyparaphenylene-3,4' -diphenylether terephthalamide fiber (made by Teijin Limited, product name: TECHNORA™) while the meta-aramid fiber includes, for instance, polymetaphenylene isophthalamide fiber (made by E. I. DuPont de Nemours and Company, product name: NOMEX™). In the present invention, para-aramid fibers are favorably used, and among them, polyparaphenylene telephthalamide fiber (made by E.I. DuPont de Nemours and Company, product name: KEVLAR™) is particularly favorably employed. Among the above para-aramid fibers, it is particularly preferable to employ an aramid fiber having a tensile modulus of not less than 90 kN/mm$^2$ is particularly favorably employed. The tensile modulus will be explained later.

As long as the above fiber is a continuous fiber as discussed above, the thickness of such fiber is not particularly limited. Any thickness capable of sufficiently exhibiting functions as structural material will be acceptable.

As for plastics that are used for reinforcing the above continuous fiber, it is possible to use an organic binder such as normal temperature- or heat-curing resin of epoxy type, polyester type, vinyl ester type, phenol type or polyimide type; an inorganic binder of normal temperature- or heat-curing type such as those of alkali metal silicate type, colloidal silica type, phosphate type, and cement type; or an organic/inorganic composite material of normal temperature- or heat-curing type. Epoxy resin is particularly preferable from among those. Moreover, a particularly preferable one from among those epoxy resins is an epoxy resin having a radiation resistance of not less than 90 MGy. A test for measuring the radiation resistance will be explained later.

The structural material used according to the present invention takes a form of a braid. A conventionally known means may be employed as the method for manufacturing such a braid, wherein a braiding machine (braid making machine) is usually used to make up an arbitrary braid form such as round braid, square braid and flat braid. For instance, four yarns are prepared wherein the strings on the right-hand side or on the left-hand side are alternately disposed in the center for build up. The number of yarns used for the manufacture of the braid is not limited to 4, but it is possible to use a desired number such as 8, 12 or 16 etc.

The shape of the structural material used according to the present invention may be either straight or bent, and shall be selected at request. The bent shape may either be laid U-shaped, L-shaped, U-shaped, or spiral and also polygonal such as triangular, rectangular, pentagonal, and hexagonal. However, the shape is not limited to those but it is possible to employ those that have been bent into various shapes in individual cases.

The structural material used according to the present invention may be arranged, at request, in that granular materials such as sand or silica may be adhered to the surface thereof to improve bond strength to concrete after impregnating a plastic to a braided continuous fiber. While the grain size of such granular materials is arbitrary unless the purpose of the present invention is not harmed, it is preferably within the range of approximately 0.1 to 5 mm.

While steps of manufacturing the structural materials used according to the present invention may be performed by methods known per se, they will be hereinafter explained in details. The manufacturing process may be divided into (1) a step of manufacturing yarns from a continuous fiber and braiding the yarns, (2) a step of impregnating a resin to the resulting braided yarns, (3) a step of curing the impregnated resin, and (4) a step of cutting the resulting resin-impregnated braid. When desired, it is also possible to include a step of adhering solid granular materials such as sand, etc. to the resin-impregnated braid. Since there are some differences between the steps of manufacturing straight and bent shaped products, explanations will now be made.

Processes of manufacturing straight structural materials used according to the present invention may be performed, for example, through (1) a step of manufacturing yarns from a continuous fiber and braiding the yarns, (2) a step of impregnating a resin to the resulting braid, (3) a step of curing the impregnated resin and optionally adhering sand thereto if required and (4) a step of cutting the resulting resin-impregnated braid.

Then, processes of manufacturing bent structural materials maybe performed, for example, through (1) a step of manufacturing yarns from a continuous fiber and braiding the yarns, (2) a step of impregnating a resin to the resulting braided yarns and optionally adhering sand thereto, (3) a step of setting the braided yarns to a molding frame of desired bent shape, (4) a step of curing the impregnated resin, and (5) a step of cutting the resulting resin-impregnated braided yarns.

Another preferred processes of manufacturing straight structural materials used according to the present invention will now be explained. For instance, strands of 6,000 denier made of yarns comprised of para-aramid fiber of approximately 10 denier are made up into an 8-yarn round braid to manufacture a braid having a diameter of approximately 2.5 mm. The resulting braid is made to run between slack rollers to apply slacks between the respective strands and yarns, whereupon the slacked braid construction is made to pass through an impregnating tank containing therein a binder such as epoxy resin to impregnate the binder to the braid construction.

Then, the excessive binder on the braid surface that has been impregnated with the binder is wiped off by an squeeze for wiping excessive binder off which is provided above the impregnating tank, and the braid that has been impregnated with the binder is then made to run between a winding caterpillar anda tension adjustingcaterpillarwhile controlling the tension to a desired one, to pass through a first heating furnace wherein the temperature is set to be approximately 80 to 120°C to achieve reduction of the viscosity of the binder, deaeration and defoaming, so that the binder is sufficiently impregnated between the respective yarns constituting the braid. Thereafter, the excessive binder on the braided fiber surface is wiped off by a squeeze for wiping the excessive binder off that is provided on an exit side of the first heating furnace, and granular materials such as sand or silica fumes having a grain size of approximately 0.1 to 5 mm are adhered onto its surface through dropping and supplying from a hopper, and the braid adhered with such granular materials is made to pass through a second heating furnace set to a temperature of approximately 120 to 250°C to achieve main curing. The braid is then made to pass through a cooling furnace set to a temperature of not more than approximately 80°C to cool the construction to normal temperature, and is cut into a desired length by means of a cutter.

When manufacturing bent structural materials used according to the present invention, a braided fiber material is slacked, impregnated with a resin, and set into a molding frame having a desired shape. For instance, when an L-shaped structural material is to be made, the resin is impregnated to the braided fiber, and sand is adhered thereto at request. The braided fiber is then set into, for instance, a square molding frame, and the impregnated resin is cured in the heating furnace. Upon finally cutting, for instance, midpoints of respective sides of the resin impregnated braid that has been cured and molded into a square shape, it is possible to obtain a bent structural material according to the present invention

The structural material used according to the present invention exhibits superior alkali resistance, heat resistance, electric resistivity, electromagnetic permeability, bond stress with concrete, tensile strength, tensile modulus and magnetic susceptibility of specific values. As for the continuous fiber and plastic that are a starting material for the structural materials of the present invention, it is possible to employ a starting material having specific physical properties of specific values for further improving properties thereof. For instance, by regulating the above tensile modulus in case of the continuous fiber and the radiation resistance in case of the plastic, further improvements in its physical properties can be expected. Manufacture of the structural material of the present invention is performed in accordance with the above manufacturing method and further by setting various conditions at request such that structural materials having properties of specific values as recited in (1) above can be obtained. Such specific manufacturing method will be explained in details in the following Examples. While regulations are made in the present invention by using values for the respective properties that have been listed above, methods for measuring such values will also be described in details.

The tensile strength and tensile modulus according to the present invention are obtained in accordance with the tensile strength test (draft) for continuous fiber reinforcing materials in conformity with JSCE-E531-1995 as regulated by the Japan Society of Civil Engineers.

For performing a tensile test, samples are first manufactured. For instance, strands of e.g. 10,000 denier made of para-aramid fiber of e.g. 10 denier are braided into a e.g. 16-lines round braid, and impregnated with an epoxy resin, followed by performing the above steps to obtain a structural material according to the present invention. At this point, the sectional area of the structural material is measured. For instance, 5 samples of uniform length are prepared from the obtained structural materials. The structural material is mounted to an AG-250KNI-type tensile tester made by Shimadzu Corporation, and tensile tests are performed at a load velocity of e.g. 300 N/mm$^2$ per minute wherein strains and loads were measured and recorded at equal intervals until tensile rupture is caused. The tensile load shown at the moment of the sample rupture is defined to be maximum tensile load.

A load-strain curve is drawn on the basis of the measured loads and strains for all of the measured 5 samples.

The tensile strength is given by the following equation:

$$\mathbf{fu = Fu/A}$$

wherein fu denotes tensile strength (N/mm$^2$), Fu denotes maximum tensile load (N) and A denotes sectional area of the sample (mm$^2$).

By using the above equation, the tensile strength of all 5 samples is calculated. Where an average value of the tensile strengths of the 5 samples is not less than 1.0 kN/mm$^2$, such samples are deemed to be an acceptable product.

The tensile modulus is given by the following equation based on the obtained load-strain curve by using values corresponding to 20% and 60% of the maximum tensile load:

$$\mathbf{E = \Delta F/(\Delta \varepsilon \cdot A),}$$

wherein E is a tensile modulus (N/mm$^2$), $\Delta F$ is a load difference between two points corresponding to 20% and 60% of the maximum tensile load (N), $\Delta \varepsilon$ is a strain difference between two points corresponding to 20% and 60% of the maximum tensile load, and A sectional area of the sample (mm$^2$).

The tensile modulus of all 5 samples is obtained from the above equation. Where an average value of the tensile modulus of the 5 samples satisfies a reference value, that is, not less than 60 kN/mm$^2$, such samples are deemed to be an acceptable product.

The alkali resistance is measured in accordance with the alkali resistance test for continuous fiber reinforcing materials (draft) in conformity with JSCE-E538-1995 as regulated by the Japan Society of Civil Engineers. In the alkali resistance test, a sample is immersed in an alkali solution for a specified time, and the tensile test is performed to measure the tensile strength, and then comparison of the tensile strengths is made prior to and after the immersion in the alkali solution. The tensile test is performed in accordance with the tensile testing method for continuous fiber reinforcing materials (draft) JSCE-E531-1995.

More particularly, for performing the alkali resistance test, samples are manufactured similarly as above. For instance, a strand of e. g. 10,000 denier made of para-aramid fiber of e.g. 10 denier are braided into a e.g. 16-yarn round braid and impregnated with an epoxy resin, followed by carrying out the steps to obtain a structural material according to the present invention. At this point, a sectional area of such structural material is measured. For instance, 5 samples of uniform length are prepared from the obtained structural materials. These samples are then mounted to an alkali immersion device. At an arbitrary point in time during the immersion period, tensile tests are performed for the respective samples. The tensile test is performed in accordance with the above "tensile testing method for continuous fiber reinforcing materials (draft)". That is, the structural material is mounted to an AG-250KNI-type tensile tester made by Shimadzu Corporation, and tensile tests are performed at a load velocity of e.g. 300 N/mm$^2$ per minute wherein strains and load velocities were measured and recorded at equal intervals until tensile rupture is caused. The tensile load shown at the moment of the sample rupture is defined to be maximum tensile load.

The alkali solution that is used in the alkali resistance test is an alkali solution corresponding to the composition of a porous solution contained in concrete, wherein the present invention employs an alkali solution which is a solution obtained by dissolving calcium hydroxide into an aqueous solution containing sodium chloride of 3 weight% until it is saturated and having a pH of 13. While the saturated amount of calcium hydroxide changes depending on the temperature of the saturated calcium hydroxide solution, each saturated solution of various temperatures are prepared. Measurement is performed in the present invention for the four measurement temperatures of room temperature, 40°C, 60°C, and 80°C.

The tensile strength is given by the following equation:

$$fu = Fu/A$$

wherein fu denotes tensile strength (N/mm$^2$), Fu denotes maximum tensile load (N), and A denotes sectional area of the sample (mm$^2$).

The tensile strengths are measured prior to and after the alkali immersion to obtain the tensile strength retention by the equation:

$$R = (fu_1/fu_0) \times 100$$

wherein R denotes tensile strength retention (%), $fu_0$ denotes tensile strength (N/mm$^2$) prior to alkali immersion, and $fu_1$ denotes tensile strength (N/mm$^2$) after alkali immersion.

As for the thus obtained tensile strength retention in the alkali resistance test, tensile strength retentions of all 5 samples are obtained. Where an average value of the tensile strength retentions of the 5 samples is not less than a reference value, that is, the tensile strength retention is not less than 90% over 1,500 hours of alkali immersion period, such samples are deemed to be an acceptable product.

The heat resistance of the structural material used according to the present invention is measured in accordance with the tensile testing method for continuous fiber reinforcing materials (draft) in conformity with JSCE-E531-1995 as regulated by the Japan Society of Civil Engineers. The tensile test is performed after performing heat treatment for 1 hour at 220°C. Operations are similar to those of the above-described method wherein samples are similarly manufactured, and tests are performed upon preparing, for instance, 5 samples of identical length. As for the thus obtained tensile strength retention of the heat resistance test, tensile strength retentions of all 5 samples are obtained. Where an average value of the tensile strength retentions of the 5 samples is not less than a reference value, that is, the tensile strength retention is not less than 90% after performing heat treatment for 1 hour at 220°C, such samples are deemed to be an acceptable product.

The electric resistance test of the structural material used according to the present invention is performed in accordance with JIS C 6481 "Method for testing copper-clad lamination for printed circuit boards", wherein tests are performed upon preliminarily treating samples. In the preliminary treatment, samples are maintained at 20±2°C for 96 hours in an atmosphere of a relative humidity of 60%. In the measurement, an average is obtained upon performing tests for, e.g. 5 samples. The electrical insulation test is performed by using a TR-42 type device manufactured by Takeda Riken. As for the thus obtained electric resistivity, the electric resistivities of all 5 samples are obtained. Where an average value of the electric resistivity of all 5 samples is a reference value, that is, a volume resistivity of not less than 10$^{13}$ Ω·cm, such samples are deemed to be an acceptable product.

The test of electromagnetic permeability of the structural material used according to the present invention is performed in accordance with the Advantest method as recited on page 1059 of Summaries of Annual Meeting on 1996 of the Architectural Institute of Japan. Shield measurement is performed by using a shield material evaluator of an electromagnetic wave shield room of Hazama Technical Research Institute. Using this device, a low impedance magnetic field up to a frequency of 1,000 MHz and a high impedance electric field are generated, and shielding effects with respect to magnetic fields and electric fields of respective shield materials are measured and evaluated. Tests are performed upon preparing, for instance, 5 samples. As for the thus obtained electromagnetic permeability, the electromagnetic permeability of all 5 samples is obtained. Where an average value of the electromagnetic permeability of the 5 samples satisfies a reference value, that is, where the electromagnetic permeability is substantially 100%, such samples are deemed to be an acceptable product.

The concrete bond stress test of the structural material of the present invention is performed in accordance with the bond strength testing method between continuous fiber reinforcing material and concrete by a pulling test of JSCE-E539-1995 (draft) as regulated by the Japan Society of Civil Engineers. The test is performed upon preparing, for instance, 5 samples. As for the thus obtained bond stress of concrete, concrete bond stresses of all 5 samples are obtained. Where an average value of the concrete bond stress of all 5 samples satisfies a reference value, that is, where it is 100 to 150 kgf/cm$^2$ when the amount of slippage at free side is 2 mm, such samples are deemed to be an acceptable product. In the test results of concrete bond stress, the bond stress value of the structural material of the present invention is a value that is not less than approximately 10 times the concrete bond stress value of reinforcing steel bar. This indicates a result that the structural material of the present invention has high bond strength to concrete.

A test for magnetic susceptibility of the structural material of the present invention is performed in accordance with JIS C 2501. The test is performed upon preparing, for instance, 5 samples. As for the thus obtained magnetic susceptibility, the magnetic susceptibility of all 5 samples is obtained. Where an average value of the magnetic susceptibility of the 5 samples satisfies a reference value, that is, where the magnetic susceptibility is substantially 0 H/m, that is, no magnetization is confirmed when measurement is performed in the present testing method, such samples are deemed to be an acceptable product. In the test results of magnetic susceptibility, the magnetic susceptibility of the structural material of the present invention is remarkably smaller than that of reinforcing steel bar. This indicates a result that the structural material of the present invention is of low magnetic properties.

The radiation resistance test of epoxy resins is performed in accordance with a known radiation resistance testing method. Such methods may, for instance, include a method of performing a pulling test upon irradiating electron rays or radioactive rays such as $\gamma$-rays and measuring the tensile strength, or a method of performing an interlayer shear test and measuring a shear strength, and it is confirmed through such tests that the strength of the sample is not lowered. According to the present invention, where not less than 90% of the strength of the sample is maintained also upon irradiation of radioactive rays of not less than 90 MGy onto the sample, such sample is deemed to be an acceptable product. When the structural material of the present invention is impregnated with an epoxy resin exhibiting large radiation resistance, it will be possible to utilize the materials at places where they are exposed to a large amount of radiation, so that its versatility is further expanded. Places at which materials are exposed to a large amount of radiation include, for instance, fusion reactors and nuclear power facilities.

As explained so far, the structural material used according to the present invention exhibits many superior properties, so that it may be utilized in a large variety of fields. Unlike reinforcing steel bar, such structural material is of light weight, so that its handling is easy, and the present invention is suitably employed not only for constructing buildings but also for bridges, roads or underground structures.

Structures that have been established by using the structural material according to the present invention include, for instance, IT buildings, hospitals, computer centers, data centers, research institutes, educational institutes, bridges, railroads, roads, underground structures, and general housings, wherein the present invention is particularly suitably employed for IT buildings. IT stands for information technology, and IT buildings are buildings in electrically and magnetically stable environment in which electronic appliances and electric equipments such as computers, etc. can be stably and safely applied.

Where electromagnetic waves from the exterior are to be shielded in the above buildings, the buildings shall be constructed using the structural material of the present invention and materials that reflect electromagnetic waves. When a building is constructed using the structural material of the present invention instead of reinforcing steel and when outermost walls are formed of materials that shield electromagnetic waves, electromagnetic waves from the exterior are shielded. Moreover, electromagnetic waves that are generated inside of the building will not be leaked to the exterior, and since the structure is formed by using the structural material of the present invention, it is neither magnetic nor conductive, and electric corrosion caused by electromagnetic waves within the building will not be caused. No malfunctions and damages of electric and electronic appliances will be caused, either.

When a building is constructed upon using an electromagnetic permeable material for only one side surface of the building while the remaining side surfaces are formed by using materials that shield electromagnetic waves, electromagnetic waves are allowed to enter only from the surface that is formed by using the electromagnetic permeable material, so that it is possible to selectively receive or emit electromagnetic waves to particular portions of the building.

When the structural material of the present invention is entirely used as materials for constructing a building (for instance, materials substituting reinforcing steel or materials constituting wall surfaces), it is possible to construct a building of superior externally communicating functions. Also, when constructing buildings that are open in terms of electromagnetic environments, peripheral electric and electronic appliances are not badly affected because the structural material of the present invention is neither magnetic nor conductive.

Structures that are constructed in the above-described manner are comprised by using the structural material of the present invention so that they are not conductive. Accordingly, no electromagnetic induction is caused also upon occurrence of lightning, leak current or stray current, and therefore no bad influences such as damages of electric and electronic appliances are caused. Strengths of structures are secured because of no occurrence of electric corrosion.

Since the structural material of the present invention will not magnetize, it is suitably employed for buildings in which high magnetic-nuclear magnetic resonance apparatuses are provided or buildings in which equipments generating magnetic fields are provided. By using the structural material of the present invention in buildings provided with supercomputers, super high-rise buildings (super-skyscrapers), floating bridges, bridge beams of railway tracks or offshore structures, it will be possible to construct structures free from danger of current, magnetization and corrosions caused thereby.

Examples

The present invention will be further explained in details with reference to Examples. However, it goes without saying that the present invention is not limited thereto.

Example 1

8 yarns of 72,000 denier in which 12 pieces of KEVLAR 49 (manufactured by Du Pont-Toray Co. , Ltd.) of 6,000 denier were stranded were manufactured and respectively wound onto bobbins. The thus obtained 8 bobbins were set to a braiding machine to manufacture round braids, whereby a braid of a diameter of approximately 9 mm was obtained.

The obtained braids were made to run between rollers for slack the braids, and they were then inserted into a resin impregnating tank filled with an epoxy resin of a resin temperature of 35 to 40°C for impregnating the resin. The excessive epoxy resin on the surface of the braids impregnated with the resin was wiped off by using a squeeze for wiping excessive resin off, and the epoxy resin impregnated braids were made to run between a winding caterpillar and a tension adjusting caterpillar for curing the resin. At this time, the velocity of the manufacturing line was set to 4.5 m/minute and a curing tension for the tension adjusting caterpillar to 200 kgf. The curing process was performed by making the braids pass through first to sixth furnaces, wherein the first furnace was set to 90°C, the second furnace to 130°C, and the third to fifth furnaces to 140°C while the sixth furnace was for cooling. Sand applying processes were performed between the second and third furnaces. After passing through the sixth furnace, the resin impregnated and cured braids were wound by a winding device and cut to be of a length of 8 m to obtain a straight structural material.

Upon testing the thus obtained structural materials through the above-described tests, all values satisfied reference values.

Example 2

Braids were manufactured similarly to Example 1. Introduction cords were then attached to the tip ends of such braids.

Rectangular molding frames were fixed on a turntable. On the other hand, the thus obtained braids were made to run between slack rollers for slacking the braids, and they were then inserted into a resin impregnating tank filled with an epoxy resin of a resin temperature of 35 to 40°C for impregnating the resin. The resin impregnated braids were supplied to tension holding rollers to apply sand thereto, and the introduction cords attached to the tip ends of the resin impregnated braids were fixed at columns of the molding frames. The turntable was rotated and the braids were wound around the molding frames whereupon aftermost ends of the braids were fixed to columns of the molding frames. The braids wound around the molding frames were put into a curing tank of 180°C with the whole molding frame to make them cure for 3 hours. After curing of the resin, rectangular cutting frames were attached to the molding frames to perform cutting at respective midpoints of the rectangles to obtain an L-shaped structural material.

Upon testing the thus obtained structural materials through the above-described various tests, all values satisfied reference values.

Industrial Applicability

The low magnetic and low conductive structural material of the present invention having improved electromagnetic permeability exhibits many superior properties besides being extremely low magnetic and low conductive so that its availability is very large. Since the said structural material is low magnetic and low conductive, it is possible to prevent malfunctions or damages of electric and electronic appliances caused through lightning current, leak current, induced current, eddy current or stray current originating therefrom. Moreover, since no electric corrosion is caused, it is possible to secure strength of the building, and since the material is of light weight, its handling is easy. Buildings employing the structural material of the present invention will be stable in view of electromagnetic environment because various problems such as ghost phenomena, etc. hardly occur, so that they can be used for a variety of purposes.

**Claims**

1. The use of a low magnetic and low conductive structural material having an improved electromagnetic permeability for the construction of a building, comprising a straight or bent fiber-reinforced plastic wherein braids made of continuous fiber are reinforced with a plastic, **characterized in that**

   (1) the said structural material is alkali resistant with a tensile strength retention of not less than 90% over 1,500 hours, measured in accordance with JSCE-E538-1995,
   (2) the said structural material is heat resistant with a tensile strength retention of not less than 90% after performing heat treatment at 220°C for 1 hour, measured in accordance with JSCE-E531-1995,
   (3) the said structural material has a volume resistivity with an electric resistivity of not less than $10^{13}$ Ω·cm, measured in accordance with JIS C 6481,
   (4) the said structural material has an electromagnetic permeability of substantially 100%, measured in accordance with the Advantest method as recited on page 1059 of The Collection of Synopsis of the Architectural Institute of Japan Academic Lecture Meeting of 1996,
   (5) the said structural material has a bond stress of 100 to 150 kgf/cm$^2$ to concrete when the amount of slippage at free side is 2 mm, measured in accordance with JSCE-E539-1995,
   (6) the said structural material has a tensile strength of not less than 1.0 kN/mm$^2$, measured in accordance with JSCE-E531-1995, and a tensile modulus of not less than 60 kN/mm$^2$, measured in accordance with JSCE-E531-1995, and
   (7) the said structural material has a magnetic susceptibility of substantially 0 H/m, measured in accordance with JIS C 2501.

2. The use of claim 1, wherein the continuous fiber is a para-aramid fiber.

3. The use of claim 2, wherein the para-aramid fiber has a tensile modulus of not less than 90 kN/mm$^2$, measured in accordance with JSCE-E531-1995.

4. The use of claim 1, wherein the plastic is an epoxy resin.

5. The use of claim .4, wherein the epoxy resin has a radiation resistance of not less than 90 MGy.

6. The use of claim 1, wherein the building is an IT building.

**Patentansprüche**

1. Verwendung eines schwach magnetischen und schwach leitfähigen Strukturmaterials mit verbesserter elektromagnetischer Permeabilität für die Konstruktion eines Gebäudes, umfassend einen geraden oder gekrümmten faserverstärkten Kunststoff, wobei Umflechtungen aus Endlosfasern mit Kunststoff verstärkt sind, **dadurch gekennzeichnet, dass**

   (1) das Strukturmaterial alkalibeständig ist, wobei es eine Zugfestigkeitsretention von nicht weniger als 90 % über 1.500 Stunden, gemessen gemäß JSCE-E538-1995, aufweist,
   (2) das Strukturmaterial hitzbeständig ist, wobei es eine Zugfestigkeitsretention von nicht weniger als 90 % nach dem Durchführen einer Wärmebehandlung bei 220 °C für 1 Stunde, gemessen gemäß JSCE-E531-1995, aufweist,
   (3) das Strukturmaterial einen spezifischen Volumenwiderstand mit einem spezifischen elektrischen Widerstand von nicht weniger als $10^{13}$ Ω·cm, gemessen gemäß JIS C 6481, hat,
   (4) das Strukturmaterial eine elektromagnetische Permeabilität von im Wesentlichen 100 %, gemessen gemäß dem Advantest-Verfahren, wie auf Seite 1059 von The Collection of Synopsis of the Architectural Institute of Japan Academic Lecture Meeting 1996 ausgeführt, hat,
   (5) das Strukturmaterial eine Haftspannung von 100 bis 150 kgf/cm$^2$ an Beton, wenn das Schlupfausmaß an der freien Seite 2 mm beträgt, gemessen gemäß JSCE-E539-1995, hat,
   (6) das Strukturmaterial eine Zugfestigkeit von nicht weniger als 1,0 kN/mm$^2$, gemessen gemäß JSCE-E531-1995, und eine Dehngrenze von nicht weniger als 60 kN/mm$^2$, gemessen gemäß JSCE-E531-1995, hat und
   (7) das Strukturmaterial eine magnetische Suszeptibilität von im Wesentlichen 0 H/m, gemessen gemäß JIS C 2501, hat.

2. Verwendung nach Anspruch 1, wobei die Endlosfaser eine Para-aramidfaser ist.

3. Verwendung nach Anspruch 2, wobei die Para-aramidfaser eine Dehngrenze von nicht weniger als 90 kN/mm$^2$, gemessen gemäß JSCE-E531-1995, hat.

4. Verwendung nach Anspruch 1, wobei der Kunststoff ein Epoxidharz ist.

5. Verwendung nach Anspruch 4, wobei das Epoxidharz eine Strahlungsbeständigkeit von nicht weniger als 90 MGy hat.

6. Verwendung nach Anspruch 1, wobei das Gebäude ein IT-Gebäude ist.

**Revendications**

1. Utilisation d'un matériau de construction faiblement magnétique et faiblement conducteur comportant une perméabilité électromagnétique améliorée, comprenant un plastique renforcé par fibres droit ou courbe dans lequel des tresses constituées de fibres continues sont renforcées avec un plastique, **caractérisé en ce que**

   (1) ledit matériau de construction est résistant aux alcalis avec une conservation de résistance à la traction non inférieure à 90 % sur 1 500 heures, mesurée selon JSCE-E538-1995,
   (2) ledit matériau de construction est résistant à la chaleur avec une conservation de résistance à la traction non inférieure à 90 % après avoir effectué un traitement thermique à 220 °C pendant 1 heure, mesuré selon JSCE-E531-1995,
   (3) ledit matériau de construction a une résistivité transversale avec une résistivité électrique non inférieure à $10^{13}$ Ω·cm, mesurée selon JIS C 6481,
   (4) ledit matériau de construction a une perméabilité électromagnétique égale à sensiblement 100 %, mesurée selon le procédé d'Advantest tel qu'énoncé à la page 1059 du recueil de résumés de l'« Architecture Institut of Japan Academic Lecture Meeting » de 1996,
   (5) ledit matériau de construction a un effort d'adhérence de 100 à 150 kgf/cm$^2$ avec du béton quand la quantité de glissement sur le côté libre est de 2 mm, mesuré selon JSCE-E539-1995,
   (6) ledit matériau de construction a une résistance à la traction non inférieure à 1,0 kN/mm$^2$, mesurée selon JSCE-E531-1995, et un module en traction non inférieur à 60 kN/mm$^2$, mesuré selon JSCE-E531-1995, et
   (7) ledit matériau de construction a une susceptibilité magnétique égale à sensiblement 0 H/m, mesurée selon JIS C 2501, pour la construction d'un bâtiment.

2. Utilisation selon la revendication 1, dans laquelle la fibre continue est une fibre para-aramide.

3. Utilisation selon la revendication 2, dans laquelle la fibre para-aramide a un module en traction non inférieur à 90 kN/mm$^2$, mesuré selon JSCE-E531-1995.

4. Utilisation selon la revendication 1, dans laquelle le plastique est une résine époxyde.

5. Utilisation selon la revendication 4, dans laquelle la résine époxyde a une résistance aux rayonnements non inférieure à 90 MGy.

6. Utilisation selon la revendication 1, dans laquelle le bâtiment est un bâtiment réservé aux technologies de l'information.

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2002326285 A